# EUROPÄISCHE PATENTSCHRIFT

(11) **EP 3 124 648 B1**
(45) Veröffentlichungstag und Bekanntmachung des Hinweises auf die Patenterteilung: **28.03.2018**
(21) Anmeldenummer: 15179405.4
(22) Anmeldetag: 31.07.2015
(51) Int. Cl.: C23C 14/56, C23C 14/24, C23C 14/26

(54) **VERDAMPFERSYSTEM SOWIE VERDAMPFUNGSVERFAHREN FÜR DIE BESCHICHTUNG EINES BANDFÖRMIGEN SUBSTRATS**
EVAPORATOR SYSTEM AND EVAPORATION METHOD FOR COATING A STRIP-SHAPED SUBSTRATE
SYSTEME D'EVAPORATEUR ET PROCEDE D'EVAPORATION POUR LE REVETEMENT D'UN SUBSTRAT EN FORME DE BANDE

(43) Veröffentlichungstag der Anmeldung: 01.02.2017
(73) Patentinhaber: Hilberg & Partner GmbH, 63512 Hainburg (DE); ONLINK Technologies GmbH, 63512 Hainburg (DE)
(72) Erfinder: HILBERG, Reinhold, 63543 Neuberg / Ravolzhausen (DE); SCHAFSTECK, Klaus, 63150 Heusenstamm (DE)
(74) Vertreter: Staudt, Armin Walter

(56) Entgegenhaltungen:
- WO-A1-2010/080268
- WO-A2-2009/064731
- JP-A- 2007 270 297
- US-A1- 2013 186 339

## Beschreibung

### Technisches Gebiet

Die vorliegende Erfindung betrifft ein Verdampfersystem zur Beschichtung eines in einer Beschichtungsebene bewegten, bandförmigen Substrats mit einem Beschichtungsmaterial.
- mit einer Verdampferbank, die eine Vielzahl von Induktionsverdampfern aufweist, die unterhalb der Beschichtungsebene angeordnet sind und die jeweils einen Tiegel zur Aufnahme des zu verdampfenden Beschichtungsmaterials und eine den Tiegel umgebende Induktions-Heizspule umfassen,
- mit einem Hochfrequenzgenerator, mittels dem ein Heizwechselstrom in die Induktions-Heizspule eingespeist und ein primäres elektromagnetisches Feld erzeugt wird, das durch induktive Einkopplung den Tiegel erhitzt,
- und mit einer Stelleinrichtung, mittels der der Heizwechselstrom für jede der Heizspulen individuell eingestellt wird.

Weiterhin geht es in der Erfindung um ein Verfahren zum Beschichten eines bandförmigen Substrats mit einem Beschichtungsmaterial durch Verdampfung.

Für die Verpackung von Lebensmitteln sind Verpackungsmaterialien erforderlich, die eine gute Sperrwirkung gegenüber Sauerstoff, Wasserdampf und Aromastoffen aufweisen. Diese werden häufig durch Aufdampfen einer dünnen Barriereschicht, beispielsweise aus Aluminium, auf einem folien- oder bandförmigen Halbzeug (Substrat) erzeugt. Auf der metallischen Barriereschicht wird typischerweise eine Schutzschicht aus Polymermaterial aufgebracht. Für Anwendungen, bei denen Transparenz und geringe Mikrowellenabsorption gewünscht ist, werden Barriereschichten auf Basis von Metalloxiden, insbesondere SiO₂, Al₂O₃ und MgO erzeugt.

Für die Herstellung derartiger Beschichtungen sind thermische Verdampfungsverfahren (engl.: Physical Vapor Deposition; kurz: PVD) gebräuchlich. Dabei wird das zu verdampfende Material in einem Verdampfer erhitzt, so dass es in den gasförmigen Zustand übergeht und die verdampften Materialteilchen als Schicht auf dem oberhalb des Verdampfers befindlichen Substrat kondensieren.

Dabei stellt sich die grundlegende Anforderung einer möglichst gleichmäßigen Schichtdicke auf dem Substrat. Bedampfungslücken - sogenannte Pinholes - sind beispielsweise bei der Herstellung von Barriereschichten auf Behälterkartonagen zum Einsatz in der Lebensmittelindustrie nicht akzeptabel. Bei Kondensatorfolien bewirken ungleichmäßige Beschichtungsstärken elektrisch unterschiedliche Leistungsdaten bei nominell gleichen Kondensatoren.

### Stand der Technik

Zur kontinuierlichen Bedampfung von Bändern und Folien großer Breite schlägt die EP 0 474 964 B1 ein Verdampfersystem vor, bei dem eine Vielzahl von Verdampfern gleicher Bauart zu einer sogenannten Verdampferbank zusammengefasst ist. Die Verdampfer sind als Tiegel mit länglicher Form ausgeführt, die als "Verdampferschiffchen" bezeichnet werden. Sie bestehen aus elektrisch leitendem Werkstoff und sind daher durch direkten Stromdurchgang beheizbar. Die Verdampferschiffchen sind äquidistant in mindestens zwei parallelen Reihen angeordnet, die sich senkrecht zur Bandlaufrichtung des bandförmigen Substrats erstrecken und gemeinsam eine schmale Beschichtungszone bilden. Dabei sind die Verdampferschiffchen benachbarter Reihen "auf Lücke" gesetzt. Komplexere Anordnungen unter Schrägstellung von Verdampferschiffchen sind beispielsweise in der WO 2008064894 A2 beschrieben.

Die räumliche Anordnung der Verdampfer innerhalb der Verdampferbank bestimmt die Art und Weise der Überlagerung der Verdampfungskeulen. Ziel ist eine möglichst gleichmäßige Schichtdickenverteilung über die gesamte Breite des Substrats. Im Idealfall ergibt sich ein wellenförmiges Beschichtungsprofil mit einem möglichst geringen Unterschied zwischen maximaler und minimaler Schichtdicke. Durch den oben beschriebenen Versatz "auf Lücke" reduziert sich die Zahl der Stöße von Dampfatomen untereinander (die freie Weglänge der Dampfatome liegt bei ca. 3 mm) und damit die gegenseitige Wechselwirkung der Verdampferkeulen. Dies wiederum bewirkt eine höhere Gleichmäßigkeit der aufzudampfenden Schicht.

Abgesehen von der räumlichen Anordnung der Verdampfer wird das Beschichtungsprofil jedoch durch äußere Einflüsse, wie Randeffekte, Temperaturverteilungen und die individuellen Emissions-Charakteristiken der einzelnen Verdampfer beeinflusst. Erschwerend kommt hinzu, dass das bandförmige Substrat oberhalb der Verdampferbank mit hoher Geschwindigkeit bewegt wird. Daraus ergeben sich hohe Anforderungen an die Einstellung der Verdampfungsrate der individuellen Verdampferschiffchen einer Verdampferbank.

Eine derartige individuelle Regelung der Verdampfungsrate von Verdampferschiffchen zur Verdampfung von Aluminium ist aus der DE 44 04 550 C2 bekannt. Als Sollwert der Regelung dient der elektrische Gesamtwiderstand, der sich aus der Summe der elektrischen Widerstände von Verdampferschiffchen und dem darin enthaltenen metallischen Material ergibt. Außerdem wird die Schichtdicke der Beschichtung laufend ermittelt. Als Stellwert der Regelung dient die am Verdampferschiffchen anliegende elektrische Leistung, genauer gesagt, die Betriebsspannung. Diese wird erhöht, wenn der Gesamtwiderstand abnimmt, beispielsweise aufgrund eines zu hohen Füllstandes oder infolge einer höheren Bandlaufgeschwindigkeit, die sich auf die Schichtdicke und damit mittelbar auf den Füllstand auswirkt.

Anstelle von widerstandsbeheizten Verdampferschiffchen werden in modernen Verdampfungsanlagen sogenannte "Induktionsverdampfer" eingesetzt, bei denen mittels eines Hochfrequenzgenerators hochfrequente Spannungen (im Mittelfrequenz- oder Hochfrequenzbereich) erzeugt und in eine Heizspule eingespeist werden, über die die Heizwärme durch elektromagnetische Induktion des hochfrequenten Wechselfeldes direkt in den Schmelztiegel oder in einen den Schmelztiegel umgebenden Suszeptor eingekoppelt wird. Mittels eines Induktionsverdampfers, wie beispielsweise in der JP S60152670 A beschrieben, können im Vergleich zur Widerstandsbeheizung höhere Schmelztemperaturen erreicht werden, so dass auch hochschmelzende Beschichtungsmaterialien, wie etwa die oben erwähnten oxidischen Werkstoffe, verdampft werden können.

US 2013/186339 A1 offenbart ein Verdampfersystem zur Beschichtung eines in einer Beschichtungsebene bewegten, bandförmigen Substrats mit einem Beschichtungsmaterial, beinhaltend einen Induktionsverdampfer mit einem Tiegel zur Aufnahme von zu verdampfendem Material mit einer zweigeteilten Induktionsspule, bestehend aus einer oberen und einer unteren Spule, wobei die obere und die unter Spule in entgegengesetzte Richtungen gewickelt sind.

JP 2007 270297 A beschreibt ein Vakuum-Verdampfersystem mit einer Fördereinrichtung zum reversierenden Transportieren eines Substrats in einer Beschichtungsebene entlang einer oder mehrerer Reihen von Verdampfungsquellen, die senkrecht zur Transportrichtung angeordnet sind.

### Technische Aufgabe

Auch bei einer mit Induktionsverdampfern bestückten Verdampferbank ist es wichtig, dass Beheizung und spezifische Verdampfungsraten der Verdampfer einzeln und unabhängig voneinander regelbar oder steuerbar sind, um über die Breite des zu beschichtenden Substrats die Verdampfungs- und Beschichtungsraten individuell anpassen zu können. Es hat sich aber gezeigt, dass die üblichen Regel- und Steuermaßnahmen nicht ausreichen, um Gleichmäßigkeit und Fehlerfreiheit der aufgedampften Schicht reproduzierbar gewährleisten zu können.

Der Erfindung liegt daher die Aufgabe zugrunde, ein mit Induktionsverdampfern ausgestattetes Verdampfersystem bereitzustellen, mittels dem eine hohe Qualität der aufgedampften Schicht reproduzierbar erzielt werden kann.

Außerdem liegt der Erfindung die Aufgabe zugrunde, das bekannte Verdampfungsverfahren so zu modifizieren, dass es die reproduzierbare Herstellung einer aufgedampften Beschichtung ermöglicht, die sich durch Gleichmäßigkeit und Fehlerfreiheit auszeichnet.

### Allgemeine Beschreibung der Erfindung

Hinsichtlich des Verdampfersystems wird diese Aufgabe ausgehend von einem System der eingangs genannten Gattung erfindungsgemäß dadurch gelöst, dass dem oberen und/oder dem unteren Ende der Heizspule eine Induktions-Gegenwicklung zugeordnet ist, in die ein Gegenwechselstrom einspeisbar und dadurch ein sekundäres elektromagnetisches Feld erzeugbar ist, das das primäre elektromagnetische Feld teilweise neutralisiert.

In der Verdampferbank sind die Induktionsverdampfer möglichst eng benachbart, um eine gleichmäßige Beschichtung zu erzielen, und dabei typischerweise in einer Reihe oder in zwei parallel zueinander verlaufenden Reihen angeordnet. Es wurde gefunden, dass die oben erwähnten Schwierigkeiten bei der individuellen Regelung oder Steuerung der Induktionverdampfer bei den bekannten Verdampfersystemen darauf zurückzuführen sind, dass sich die elektromagnetischen Felder der Verdampfer gegenseitig beeinflussen. Eine grundlegende Erkenntnis der Erfindung ist, dass die Veränderung von Stromstärke, Spannung oder Frequenz des Spulenstroms bei einem Induktionsverdampfer zwar dessen elektromagnetisches Feld verändert, sich gleichzeitig aber auch auf die elektromagnetischen Felder der benachbarten Induktionsverdampfer auswirkt. Denn das elektromagnetische Feld eines Induktionsverdampfers ist auch maßgeblich für Größe und Form seiner Verdampferkeule, also der örtlichen Verteilung von Beschichtungsmaterialdampf aus dem jeweiligen Verdampfer. Das bedeutet aber, dass die gewollte Veränderung der Verdampferkeule eines einzigen Induktionsverdampfers gleichzeitig eine nicht gewollte und in der Regel auch nicht überschaubare Veränderung der ihm benachbarten Verdampferkeulen mit sich bringt, und deren Veränderung wiederum die Nachbar-Verdampferkeulen (einschließlich der gewollt veränderten Verdampferkeule) beeinflusst. Diese Kopplung kann letztlich dazu führen, dass aufgrund einer kleinen Korrektur bei einem einzigen Induktionsverdampfer die Magnetfeldcharakteristik der gesamten Verdampferbank in unvorhersehbarer und nicht reproduzierbarer Weise verändert wird.

Die gegenseitige Beeinflussung der Verdampferkeulen durch die beschriebene magnetische und elektrische Kopplung der individuellen Induktionsverdampfer beeinträchtigt die Regelbarkeit und führt leicht zu einer ungleichmäßigen Schichtdickenverteilung. Diese Problematik wird dadurch verschärft, dass die Induktionsverdampfer zu Gunsten einer möglichst homogenen Beschichtung eng beieinander liegen. So beträgt der Abstand der Induktionsspulen voneinander typischerweise 30 bis 40 mm.

Um das Problem zu entschärfen, weisen beim erfindungsgemäßen Verdampfersystem einige und bevorzugt alle Induktionsverdampfer der Verdampferbank folgende Merkmale in Bezug auf ihre Einrichtung zur Energiezufuhr auf:
(1) Die der Heizspule zuzuführende elektrische Leistung ist individuell steuerbar oder regelbar.
(2) Das der Beschichtungsebene zugewandte, obere stirnseitige Ende der Heizspule oder das der Beschichtungsebene abgewandte, untere stirnseitige Ende der Heizspule oder beide Heizspulen-Enden sind unmittelbar oder mittelbar (über ein Zwischenelement) von einem Element benachbart, das zur Erzeugung eines elektromagnetischen Feldes geeignet ist. Das weitere Element ist vorzugsweise als Spule, Spirale oder als einfache Windung ausgelegt und wird hier als "Gegenwicklung" bezeichnet.

Während das primäre elektromagnetische Feld der Heizspule in erster Linie zum Beheizen des Tiegels oder eines den Tiegel umgebenden Suszeptors dient, erfüllt das sekundäre elektromagnetische Feld der Induktions-Gegenwicklung den Zweck, das elektromagnetische Feld der Heizspule einzuengen. Diese Wirkung wird im Folgenden auch als "Taillierung" bezeichnet.

Durch die Taillierung wird im Idealfall der zur Beheizung benötigte Anteil des elektromagnetischen Feldes nicht beeinflusst, und der Anteil, der dafür nicht benötigt wird und der in Richtung der elektromagnetischen Felder der Nachbarspule weist (im Folgenden auch als der "parasitäre Anteil" bezeichnet) wird vollständig eliminiert. Im Realsystem wird der parasitäre Anteil des elektromagnetischen Feldes der Heizspule verringert und das elektromagnetische Feld der Heizspule außen teilweise neutralisiert. Dabei wird das primäre elektromagnetische Feld je nach Stärke des sekundären elektromagnetischen Feldes mehr oder weniger zurückgedrängt.

Zur Erzeugung des sekundären elektromagnetischen Feldes wird in die Induktions-Gegenwicklung ein Gegenwechselstrom eingespeist, der sich vom Wechselstrom der Heizspule unterscheidet, und zwar vorzugsweise in Bezug auf seine Stärke, Frequenz oder Phase, besonders bevorzugt in Bezug auf seinen Richtungsverlauf im Raum. Sind die räumlichen Richtungen der Wechselströme in der Heizspule und in der Gegenwicklung gegenläufig, so bilden sich elektromagnetische Felder mit gegensinnig verlaufenden Feldlinien, die sich gegenseitig teilweise neutralisieren. Ein gegenläufiger Wechselstrom wird durch eine gegensinnige Anordnung der Windungen von Heizspule und Gegenwicklung bewirkt, oder - bei Heizspule und Gegenspule mit gleichem Drehsinn - durch Einspeisen des Wechselstroms an einem jeweils anderen Ende, also am oberen Ende beziehungsweise am unteren Ende der Windungen von Heizspule und Gegenwicklung.

Durch die beschriebene Taillierung des primären elektromagnetischen Feldes gelingt es, die gegenseitige Wechselwirkung und Kopplung der einzelnen Induktionsverdampfer zu verkleinern. Dadurch kann eine individuelle Leistungsanpassung der einzelnen Verdampfer der Verdampferbank ohne nennenswerte Rückkopplung auf die anderen Verdampfer vorgenommen werden, was die bislang erreichbare Beschichtungsqualität ohne hohe Zusatzkosten deutlich verbessert.

Die der Gegenwicklung zugeführte elektrische Leistung kann unabhängig von der der Heizspule zugeführten elektrischen Leistung einstellbar sein. Es hat sich aber auch als vorteilhaft erwiesen, wenn es zwischen den beiden elektrischen Leistungen eine vorgegebene Kopplung gibt. So gelingt die Taillierung des elektromagnetischen Feldes der Heizspule durch teilweise Neutralisierung besonders gut, wenn der Heizwechselstrom und der Gegenwechselstrom dieselbe Frequenz haben. Dies ist einfach dadurch zu bewerkstelligen, dass Heizspule und Gegenwicklung an denselben Hochfrequenzgenerator anschließbar sind, elektrisch miteinander verbunden sind oder, indem der Gegenwechselstrom induktiv zwischen Heizspule und Gegenwicklung erzeugt werden kann. In den beiden letztgenannten Fällen verfügt die Gegenwicklung über keine eigene Stromversorgung.

Durch die Taillierung des elektromagnetischen Feldes der Heizspule soll lediglich das Außenfeld, jedoch möglichst nicht das zum Beheizen des Tiegels benötigte Innenfeld neutralisiert werden. Grad und Umfang der Neutralisierung kann durch den Abstand der Gegenwicklung vom stirnseitigen Ende der Heizspule sowie durch die elektrische Leistung der Gegenwicklung beeinflusst werden. Im einfachsten Fall ist die Gegenwicklung einwindig oder zweiwindig und die Heizspule ist mehrwindig ausgeführt. Der Abstand zwischen Gegenwicklung und Heizspule ist vorzugsweise veränderbar. Haben Heizspule und Gegenwicklung eine gemeinsame Stromversorgung, indem sie beispielsweise ein einstückiges Bauteil bilden, so legt das Verhältnis der beiderseitigen Windungsanzahlen den Grad und den Umfang der Neutralisierung im Wesentlichen fest.

Für eine besonders wirksame, beidseitige Taillierung des primären elektromagnetischen Feldes hat es sich als vorteilhaft erwiesen, wenn dem oberen Ende der Heizspule eine obere Induktions-Gegenwicklung und dem unteren Ende der Heizspule eine untere Induktions-Gegenwicklung zugeordnet ist.

Bei einer besonders einfachen Bauform sind die Heizspule, die obere und die untere Gegenwicklung in Reihe geschaltet.

Dabei sind die Heizspule und die beiderseitigen Gegenwicklungen bevorzugt als integrales Spulen-Bauteil mit einer gemeinsamen Stromzufuhr ausgeführt. Der in das Spulen-Bauteil eingespeiste elektrische Wechselstrom verläuft in den Gegenwicklungen - in Richtung der Spulen-Mittelachse gesehen - in entgegengesetzter Richtung (beispielsweise im Uhrzeigersinn) als in der Heizspule (beispielsweise gegen den Uhrzeigersinn).

Bei einer alternativen Bauform sind die Heizspule, die obere und die untere Gegenwicklung in Reihe und dabei die obere und untere Gegenwicklung parallel zueinander geschaltet. Hierbei bilden Heizspule und Gegenwicklungen getrennte Spulenbauteile. Durch die Parallelschaltung ergibt sich - gleiche Bauform vorausgesetzt - in den Gegenwicklungen die gleiche Stromstärke und damit auch etwa gleich wirksame sekundäre elektromagnetische Felder beiderseits des primären elektromagnetischen Feldes. Diese Schaltungsanordnung erleichtert die Einstellung eines spiegelsymmetrischen elektromagnetischen Feldes; mit einer Spiegelebene, die parallel zur Beschichtungsebene verläuft.

Beim Induktionsverdampfer ist am oberen stirnseitigen Ende der Heizspule oder am unteren stirnseitigen Ende der Heizspule oder an beiden Heizspulen-Enden ein Element vorgesehen, das zur Erzeugung eines elektromagnetischen Feldes geeignet ist und das hier als "Gegenwicklung" bezeichnet wird. Die Gegenwicklung ist vorzugsweise als Spule, Spirale oder als einfache Spulenwindung ausgelegt. Sie steht in direktem elektrischen und mechanischen Kontakt mit der Heizspule oder sie bildet ein separates Bauteil.

Während die Heizspule zur Erzeugung des primären elektromagnetischen Feld in erster Linie zum Beheizen des Tiegels oder eines den Tiegel umgebenden Suszeptors dient, erfüllt die Induktions-Gegenwicklung den Zweck, ein sekundäres elektromagnetisches Feld zu erzeugen, das geeignet ist, das primäre elektromagnetische Feld einzuengen. Bezüglich der Wirkung dieser "Taillierung" auf die Ausbildung des elektromagnetischen Feldes des Induktionsverdampfers wird auf die obigen Erläuterungen zum erfindungsgemäßen Verdampfersystem verwiesen. Der Induktionsverdampfer ist für den Einsatz in diesem Verdampfersystem ausgelegt und besonders geeignet.

Zur Erzeugung des sekundären elektromagnetischen Feldes wird in die Gegenwicklung ein Gegenwechselstrom eingespeist, der sich vom Wechselstrom der Heizspule unterscheidet, und zwar vorzugsweise in Bezug auf seine Stärke, Frequenz oder Phase, besonders bevorzugt in Bezug auf seine räumliche Richtung. Sind nämlich die Richtungen der Wechselströme in der Heizspule und in der Gegenwicklung im Raum gegenläufig - haben also unterschiedlichen Drehsinn - so bilden sich elektromagnetische Felder mit gegensinnig verlaufenden Feldlinien, die sich gegenseitig teilweise neutralisieren. Ein gegenläufiger Wechselstrom wird durch eine gegensinnige Windung von Heizspule und Gegenwicklung bewirkt, oder - bei Windungen von Heizspule und Gegenspule mit gleichem Drehsinn - durch Einspeisen des jeweiligen Wechselstroms an einem anderen Ende (oberes Ende beziehungsweise unteres Ende) der jeweiligen Windung.

Die der Gegenwicklung zugeführte elektrische Leistung kann unabhängig von der der Heizspule zugeführten elektrischen Leistung einstellbar sein. Es hat sich aber auch als vorteilhaft erwiesen, wenn es zwischen den beiden Leistungen eine gewisse Kopplung gibt. So gelingt die Taillierung des elektromagnetischen Feldes der Heizspule durch teilweise Neutralisierung besonders gut, wenn der Heizwechselstrom und der Gegenwechselstrom dieselbe Frequenz haben. Dies ist einfach dadurch zu bewerkstelligen, dass Heizspule und Gegenwicklung an denselben Hochfrequenzgenerator anschließbar sind, elektrisch miteinander verbunden sind oder, indem der Gegenwechselstrom induktiv zwischen Heizspule und Gegenwicklung erzeugt werden kann. In den beiden letztgenannten Fällen verfügt die Gegenwicklung über keine eigene Stromversorgung.

Im einfachsten Fall ist die Gegenwicklung einwindig oder zweiwindig und die Heizspule ist mehrwindig ausgeführt.

Für eine besonders wirksame, beidseitige Taillierung des primären elektromagnetischen Feldes hat es sich als vorteilhaft erwiesen, wenn dem oberen Ende der Heizspule eine obere Induktions-Gegenwicklung und dem unteren Ende der Heizspule eine untere Induktions-Gegenwicklung zugeordnet ist.

Vorzugsweise sind bei dieser Ausführungsform des Verdampfers die Heizspule, die obere und die untere Gegenwicklung in Reihe geschaltet.

Dabei sind die Heizspule und die beiderseitigen Gegenwicklungen bevorzugt als integrales Spulen-Bauteil mit einer gemeinsamen Stromzufuhr ausgeführt. Der in das Spulen-Bauteil eingespeiste elektrische Wechselstrom verläuft in den Gegenwicklungen - in Richtung der Spulen-Mittelachse gesehen - in entgegengesetzter Richtung (beispielsweise im Uhrzeigersinn) als in der Heizspule (beispielsweise gegen den Uhrzeigersinn).

Der Abstand zwischen Gegenwicklung und Heizspule ist vorzugsweise veränderbar.

Hinsichtlich des Verfahrens zum Beschichten eines bandförmigen Substrats mit einem Beschichtungsmaterial durch Verdampfung wird die eingangs genannte technische Aufgabe durch ein Verfahren gelöst, das erfindungsgemäß folgende Verfahrensschritte umfasst:
(a) Transportieren des Substrats in einer Beschichtungsebene,
(b) Bereitstellen einer Verdampferbank, die eine Vielzahl von Induktionsverdampfern aufweist, die unterhalb der Beschichtungsebene angeordnet sind und die jeweils einen Tiegel zur Aufnahme des zu verdampfenden Beschichtungsmaterials und eine den Tiegel umgebende Induktions-Heizspule umfassen,
(c) Erhitzen und Verdampfen des Beschichtungsmaterials unter Einsatz eines Hochfrequenzgenerators, mittels dem ein Heizwechselstrom in die Induktions-Heizspule eingespeist und ein primäres elektromagnetisches Feld erzeugt wird, das durch induktive Einkopplung den Tiegel erhitzt,
(d) Individuelles Einstellen des Heizwechselstroms für jede der Heizspulen,
wobei Induktionsverdampfer eingesetzt werden, bei denen jeweils dem oberen und/oder dem unteren Ende der Heizspule eine Induktions-Gegenwicklung zugeordnet ist, in die ein Gegenwechselstrom eingespeist und dadurch ein sekundäres elektromagnetisches Feld erzeugt wird, das das primäre elektromagnetische Feld teilweise neutralisiert.

Beim erfindungsgemäßen Beschichtungsverfahren wird das zu beschichtende bandförmige Substrat kontinuierlich in einer horizontalen Beschichtungsebene bewegt, die oberhalb einer Verdampferbank verläuft. Diese ist mit einer Vielzahl von Induktionsverdampfern ausgestattet, die typischerweise in einer Reihe oder in mehreren Reihen angeordnet sind, wie dies aus dem Stand der Technik für Verdampferschiffchen bekannt ist; dabei können insbesondere die Induktionsverdampfer benachbarter Reihen mittig versetzt zueinander angeordnet sein. Die Verdampfungsrate der Induktionsverdampfer wird während des Bedampfungsprozesses individuell und unabhängig voneinander durch Regelung oder Steuerung des Heizwechselstroms eingestellt. Dabei können sich die elektromagnetischen Felder der Induktionsverdampfer gegenseitig beeinflussen. So kann eine Veränderung von Stromstärke, Spannung, Frequenz oder Phase des Heizwechselstroms bei einem der Induktionsverdampfer dessen elektromagnetisches Feld verändern, was sich gleichzeitig auf die elektromagnetischen Felder der benachbarten Induktionsverdampfer auswirkt. Das elektromagnetische Feld eines Induktionsverdampfers ist aber auch maßgeblich für Größe und Form seiner Verdampferkeule, also der örtlichen Verteilung von Beschichtungsmaterialdampf aus dem jeweiligen Verdampfer. Das bedeutet aber, dass die gewollte Veränderung der Verdampferkeule eines einzigen Induktionsverdampfers gleichzeitig eine nicht gewollte und in der Regel auch nicht überschaubare Veränderung der benachbarten Verdampferkeulen mit sich bringt, wobei diese Veränderung wiederum deren Nachbar-Verdampferkeulen (einschließlich der gewollt veränderten Verdampferkeule) beeinflusst. Diese Kopplung kann letztlich dazu führen, dass aufgrund einer kleinen Korrektur bei einem einzigen Induktionsverdampfer die Magnetfeldcharakteristik der gesamten Verdampferbank in unvorhersehbarer und nicht reproduzierbarer Weise verändert wird.

Die gegenseitige Beeinflussung der Verdampferkeulen durch die beschriebene magnetische und elektrische Kopplung der individuellen Induktionsverdampfer beeinträchtigt die Regelbarkeit des Heizwechselstroms und führt leicht zu einer ungleichmäßigen Schichtdickenverteilung. Um das Problem zu entschärfen, wird beim erfindungsgemäßen Verfahren eine Verdampferbank eingesetzt, bei der einige und bevorzugt alle Induktionsverdampfer ergänzend zu ihrer individuellen Steuer- oder Regelbarkeit folgende Besonderheit aufweisen:

Das der Beschichtungsebene zugewandte, obere stirnseitige Ende der Heizspule oder das der Beschichtungsebene abgewandte, untere stirnseitige Ende der Heizspule oder beide Heizspulen-Enden sind unmittelbar oder mittelbar (über ein Zwischenelement) von einer Gegenwicklung benachbart, die zur Erzeugung eines elektromagnetischen Feldes geeignet ist. Die Gegenwicklung ist vorzugsweise als Spule, Spirale oder als einfache Windung ausgelegt.

Während das primäre elektromagnetische Feld der Heizspule in erster Linie zum Beheizen des Tiegels oder eines den Tiegel umgebenden Suszeptors dient, erfüllt das sekundäre elektromagnetische Feld der Induktions-Gegenwicklung den Zweck, das elektromagnetische Feld der Heizspule einzuengen. Diese Wirkung wird hier auch als "Taillierung" bezeichnet.

Durch die Taillierung wird im Idealfall der zur Beheizung benötigte Anteil des elektromagnetischen Feldes nicht beeinflusst, und der Anteil, der dafür nicht benötigt wird und der in Richtung der elektromagnetischen Felder der Nachbarspule weist (hier auch als "parasitärer Anteil" bezeichnet) wird vollständig eliminiert. Im Realsystem wird der parasitäre Anteil des primären elektromagnetischen Feldes des Außenfieldes teilweise neutralisiert. Dabei wird das primäre elektromagnetische Feld je nach Stärke des sekundären elektromagnetischen Feldes mehr oder weniger zurückgedrängt.

Zur Erzeugung des sekundären elektromagnetischen Feldes wird in die Induktions-Gegenwicklung ein Gegenwechselstrom eingespeist, der sich vom Heizwechselstrom unterscheidet, und zwar vorzugsweise in Bezug auf seine Stärke, , Frequenz oder Phase, besonders bevorzugt in Bezug auf seine räumliche Verlaufsrichtung in der Gegenwicklung. Den sind die Richtungen der Wechselströme in der Heizspule und in der Gegenwicklung im Raum gegenläufig - haben also unterschiedlichen Drehsinn - , so bilden sich elektromagnetische Felder mit gegensinnig verlaufenden Feldlinien, die sich gegenseitig teilweise neutralisieren. Ein im Raum gegenläufiger Wechselstrom wird durch eine gegenläufige Anordnung der Windungen von Heizspule und Gegenwicklung bewirkt, also durch Spulenwindungen die - betrachtet vom Punkt des Stromeintritts - einmal im Uhrzeigersinn und einmal gegen den Uhrzeigersinn verlaufen, oder - bei gleichlaufenden Spulenwindungen von Heizspule und davon getrennter Gegenspule - durch Einspeisen des jeweiligen Wechselstroms an einem anderen Ende (am oberen Ende beziehungsweise am untere Ende) der jeweiligen Windung.

Durch die beschriebene Taillierung des primären elektromagnetischen Feldes gelingt es, die gegenseitige Wechselwirkung und Kopplung der einzelnen Induktionsverdampfer zu verkleinern. Dadurch kann eine individuelle Leistungsanpassung der einzelnen Verdampfer der Verdampferbank, ohne nennenswerte Rückkopplung auf die anderen Verdampfer vorgenommen werden, was die bislang erreichbare Beschichtungsqualität ohne hohe Zusatzkosten deutlich verbessert.

Das erfindungsgemäße Verfahren wird idealerweise unter Einsatz des Verdampfersystems gemäß vorliegender Erfindung durchgeführt.

Die der Gegenwicklung zugeführte elektrische Leistung kann unabhängig von der der Heizspule zugeführten elektrischen Leistung einstellbar sein. Es hat sich aber auch als vorteilhaft erwiesen, wenn es zwischen den beiden Leistungen eine gewisse Kopplung gibt. So gelingt die Taillierung des elektromagnetischen Feldes der Heizspule durch teilweise Neutralisierung besonders gut, wenn der Heizwechselstrom und der Gegenwechselstrom dieselbe Frequenz haben. Dies ist einfach dadurch zu bewerkstelligen, dass Heizspule und Gegenwicklung an denselben Hochfrequenzgenerator anschließbar sind, elektrisch miteinander verbunden sind oder, indem der Gegenwechselstrom induktiv zwischen Heizspule und Gegenwicklung erzeugt werden kann. In den beiden letztgenannten Fällen verfügt die Gegenwicklung über keine eigene Stromversorgung.

Durch die Taillierung des elektromagnetischen Feldes der Heizspule soll lediglich das Außenfeld, jedoch möglichst nicht das zum Beheizen des Tiegels benötigte Innenfeld neutralisiert werden. Daher ist das vom Gegenwechselstrom erzeugte elektromagnetische Feld vorzugsweise wesentlich schwächer als das vom Heizwechselstrom erzeugte elektromagnetische Feld. Grad und Umfang der Neutralisierung kann durch den Abstand der Gegenwicklung vom stirnseitigen Ende der Heizspule sowie durch die elektrische Leistung der Gegenwicklung beeinflusst werden. Daher ist der Abstand zwischen Gegenwicklung und Heizspule vorzugsweise veränderbar.

Es hat sich bewährt, wenn die Stromstärke des Gegenwechselstroms maximal 2/3 der Stromstärke des Heizwechselstroms entspricht. Dadurch ergibt beim sekundären elektromagnetischen Feld eine geringere Intensität als beim primären elektromagnetischen Feld. Als Intensität wird dabei die Stärke des von dem Hochfrequenzstrom in der betreffenden Heizspule/Gegenwicklung erzeugten Feldes verstanden.

Für eine besonders wirksame, beidseitige Taillierung des primären elektromagnetischen Feldes hat es sich als vorteilhaft erwiesen, wenn dem oberen Ende der Heizspule eine obere Induktions-Gegenwicklung und dem unteren Ende der Heizspule eine untere Induktions-Gegenwicklung zugeordnet ist.

Vorzugsweise sind dabei die Heizspule, die obere und die untere Gegenwicklung in Reihe geschaltet. Heizspule und beiderseitige Gegenwicklungen sind dabei bevorzugt als integrales Spulen-Bauteil mit einer gemeinsamen Stromzufuhr ausgeführt. Der in das Spulen-Bauteil eingespeiste elektrische Wechselstrom verläuft in den Gegenwicklungen - in Richtung der Spulen-Mittelachse gesehen - in entgegengesetzter Richtung (beispielsweise im Uhrzeigersinn - betrachtet vom Punkt des Stromeintritts) als in der Heizspule (beispielsweise gegen den Uhrzeigersinn betrachtet vom Punkt des Stromeintritts).

### Ausführungsbeispiel

Nachfolgend wird die Erfindung anhand eines Ausführungsbeispiels und einer Patentzeichnung näher erläutert. In der Zeichnung zeigt im Einzelnen in schematischer Darstellung:
- **Figur 1**: eine Ausführungsform des erfindungsgemäßen Verdampfersystems zur Beschichtung eines bandförmigen Substrats in einer perspektivischen Ansicht,
- **Figur 2**: einen Ausschnitt des Verdampfersystems in einer Seitenansicht,
- **Figur 3**: eine Anordnung von Induktionsverdampfern gemäß dem Stand der Technik in perspektivischer Ansicht, zusammen mit ihrem jeweiligen elektromagnetischen Feld,
- **Figur 4**: eine Anordnung von Induktionsverdampfern in perspektivischer Ansicht, zusammen mit ihrem jeweiligen elektromagnetischen Feld,
- **Figur 5**: eine Skizze zur Erläuterung der Veränderung der Feldverteilung des elektromagnetischen Feldes bei Überlagerung von gegenläufigen Induktionsspulenbereichen, und
- **Figur 6**: ein Blockdiagramm zur Erläuterung der Schichtdickenregelung beim erfindungsgemäßen Verfahren.

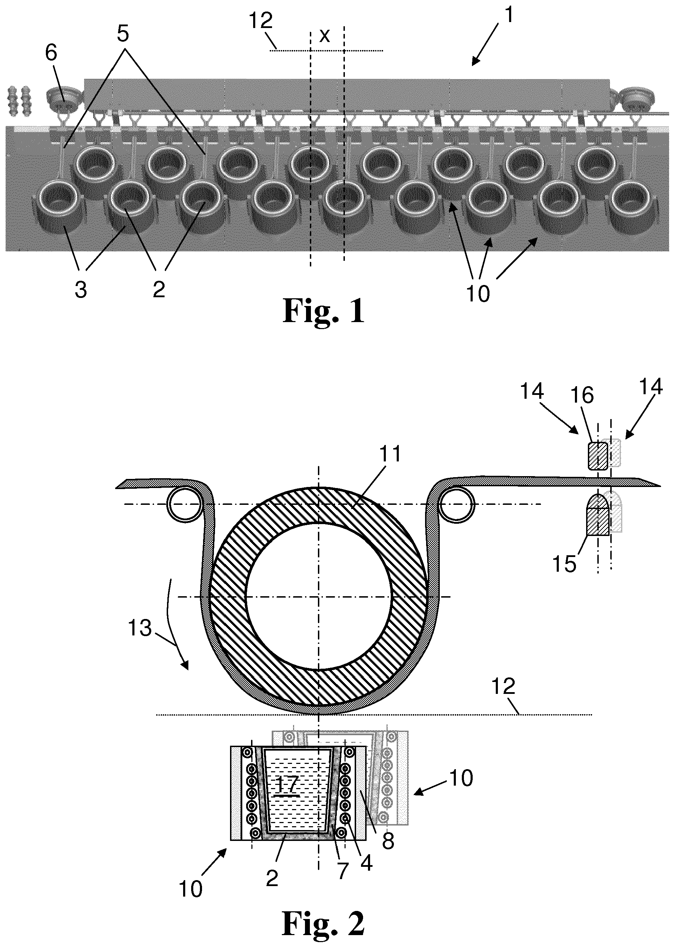

**Figur 1** zeigt schematisch ein induktives Verdampfersystem 1 zur Beschichtung eines bandförmigen Substrats 9 (in Figur 1 zu Gunsten einer besseren Erkennbarkeit des Verdampfersystems weggelassen; siehe Figur 2). Das Verdampfersystem 1 ist mit einer Verdampferbank mit insgesamt 17 baugleichen Induktionsverdampfern 10 ausgestattet, die in einer Vakuumkammer angeordnet sind.

**Figur 2** zeigt Details der Induktionsverdampfer 10. Jeder der Induktionsverdampfer 10 umfasst einen Grafittiegel 2 zur Aufnahme der zu verdampfenden Substanz 17 und eine Induktionsspule 4 zur induktiven Beheizung. Der Grafittiegel 2 ist mit Wärmeisolationsschichten aus Aluminiumoxid (7) und Grafitfilz (8) umgeben. Zwischen dem Grafittiegel 2 und der äußersten Wärmeisolationsschicht 8 befindet sich die wassergekühlte Induktionsspule 4. In der perspektivischen Darstellung von Figur 1 sind die elektrischen Zuführungen 5 für die Induktionsspule 4 aus Kupferrohr erkennbar.

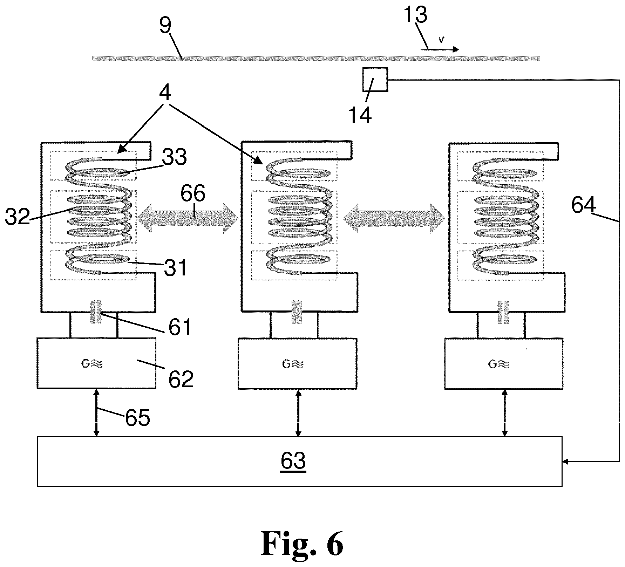

Die elektrischen Zuführungen 5 verlaufen jeweils zu einem Hochfrequenzgenerator 62 (siehe Figur 6), der in Figur 1 schematisch durch die Anschlussdose 6 symbolisiert ist. Jeder Induktionsverdampfer 10 ist über seinen Hochfrequenzgenerator 62 und eine Steuereinheit 63 (siehe Figur 6) individuell ansteuerbar. Mittels der Hochfrequenzgeneratoren 62 werden die Grafittiegel 2 induktiv aufgeheizt, indem jeweils ein hochfrequenter Wechselstrom mit einer Frequenz um 10 kHz und im Leistungsbereich von 10 bis 20 kW über die Zuführungen 6 in die jeweiligen Induktionsspulen 4 eingespeist wird. Der Induktorstrom beträgt etwa 330 A. Die Stromzufuhr (Stromstärke und Spannung) ist für jeden Induktionsverdampfer 10 mittels der Steuereinheit 63 individuell einstellbar. Die Frequenz kann bei den einzelnen Induktionsverdampfern gleich oder unterschiedlich sein.

Die Induktionsverdampfer 10 sind in zwei parallel zueinander verlaufenden Reihen angeordnet, wobei die Induktionsverdampfer 10 der einen Reihe mittig versetzt zu den Induktionsverdampfern 10 der anderen Reihe angeordnet sind. Der minimale Abstand zwischen den Induktionsspulen 4 beträgt dabei etwa 35 mm. Der Mittenabstand der Grafittiegel 2 - gemessen als Abstand "x" in einer Projektion auf eine Beschichtungsebene 12 (angedeutet mit der Bezugsziffer 12; siehe auch Figur 2) beträgt 160 mm.

Aus der Darstellung von **Figur 2** ist die Führung des zu beschichtenden Substrats 9 über eine wassergekühlte Beschichtungswalze 11 erkennbar. Die Verdampfer-Reihen der Verdampfereinheit 1 sind durch ein Paar versetzt zueinander angeordneter Induktionsverdampfer 10 symbolisiert. Bei dem Substrat 9 handelt es sich um eine Folie oder einen Karton für eine Lebensmittel-Verpackung. Das bandförmige Substrat 9 durchläuft kontinuierlich die Beschichtungsebene 12 oberhalb der Induktionsverdampfer 10 wie vom Richtungspfeil 13 angedeutet. Dabei wird mittels der Verdampfereinheit 1 einseitig ein Film aufgedampft, beispielsweise aus Aluminium.

Die Dicke des aufgedampften Films wird kontinuierlich optisch oder elektrisch gemessen. Das mit dem Film beschichtete Substrat 9 durchläuft dabei eine optische oder elektrische Messeinrichtung, die in Transportrichtung 13 dem Verdampfersystem 1 nachgeordnet ist. Die Messeinrichtung umfasst eine der Anzahl der Induktionsverdampfer 10 entsprechende Anzahl von Schichtdickensensoren 14, die über die gesamte Breite der Substrat-Bahn gleichmäßig verteilt sind und die jeweils mit der Steuereinheit 63 (siehe Figur 6) verbunden sind. Jeder Schichtdickensensor 14 besteht aus einem Sender 15 auf der einen Seite des Substrats 9 und einem Detektor 16 auf der gegenüberliegenden Substratseite. Jeder Schichtdickensensor 14 ist genau einem Induktionsverdampfer 10 zugeordnet. Ihre örtliche Position über die Substratbreite gesehen ist am Mittelpunkt derjenigen Verdampfungskeule ausgerichtet, die von dem ihr zugeordneten Induktionsverdampfer 10 erzeugt wird; der Mittenabstand der Schichtdickensensoren 14 entspricht auch dem Mittenabstand "x" der Induktionsverdampfer 10.

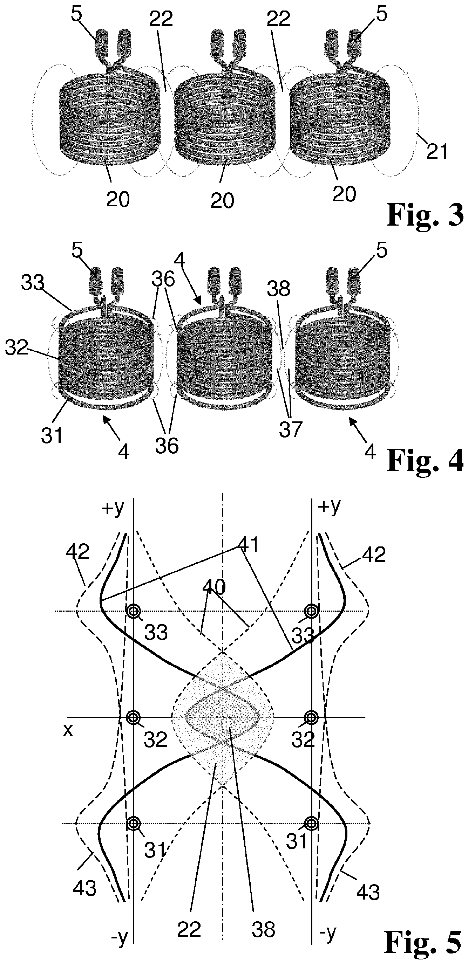

In **Figur 3** ist eine Gruppe von Induktionsspulen 20 dargestellt (ohne Grafittiegel und Wärmeisolierung), wie sie bislang in Induktionsverdampfern üblich waren. Diese bestehen aus einer mehrwindigen, einfachen Spule aus Kupferrohr mit den Stromanschlüssen 5. Die von den Induktionsspulen 20 erzeugten elektromagnetischen Felder 21 beeinflussen sich gegenseitig stark, was durch einen großen Überlappungsbereich 22 angedeutet ist.

Im Vergleich dazu ist in **Figur 4** eine repräsentative Gruppe von Induktionsspulen 4 für den Einsatz in einem Induktionsverdampfer 10 (ebenfialls ohne Grafittiegel und Wärmeisolierung) dargestellt. Diese bestehen aus einer dreigliedrigen Spule aus Kupferrohr, aus der von unten nach oben gesehen die folgenden Spulenbereiche gewickelt sind, die sich in ihrem Drehsinn voneinander unterscheiden: die untere Gegenwindung 31 mit einem ersten Drehsinn, die eigentliche Heizspule 32 mit einem zweiten Drehsinn, der sich vom ersten Drehsinn unterscheidet und die obere Gegenwicklung 33, die wiederum im ersten Drehsinn gewickelt ist. Die untere Gegenwicklung 31 ist an der unteren Stirnseite der eigentlichen Heizspule 32 vorgesehen. Sie zeigt nur eine einzige vollständige Windung, die gegenläufig zur Heizspule ist 32 verläuft und in diese in einem U-förmigen Bogen mündet. Die Heizspule 32 wird von einer Vielzahl von Windungen gebildet (im Ausführungsbeispiel sind es neun vollständige Windungen) und sie mündet wiederum an ihrem oberen stirnseitigen Ende über einen weiteren U-förmigen Bogen in die gegenläufige und einwindige obere Gegenwicklung 33. Die obere und untere Gegenwicklung 31; 33 erzeugen jeweils ein vergleichsweise schwaches elektromagnetisches Feld 36, das gegensinnig zum Feld 37 der Heizspule 32 ist. Diese Konstellation führt zu einer Taillierung des elektromagnetischen Feldes der Heizspule 32, so dass sich keine oder eine geringere gegenseitige Beeinflussung der Felder benachbarter Induktionsspulen 4 ergibt, was in Figur 3 durch das Fehlen eines Überlappungsbereichs 38 angedeutet ist.

Die Unterschiede in den Überlappungsbereichen zeigt auch schematisch die Skizze von **Figur 5****.** Für jeweils zwei benachbarte Induktionsspulen ist auf der x-Achse ist die Magnetfeldstärke der einzelnen Spulenbereiche (31; 32; 33) und der y-Achse der Abstand vom Mittelpunkt der eigentlichen Heizspule (32) aufgetragen. Die Positionen der unteren Gegenwindung 31, der eigentlichen Heizspule 32 und der obere Gegenwicklung 33 sind markiert. Die Kurven 40 mit punktiertem Linienverlauf geben schematisch den Verlauf der Magnetfeldstärke eine Heizspule wieder, wie sie in Figur 2 gezeigt ist (also ohne obere und untere Gegenwicklungen). Dabei stellt sich eine breite Verteilung der Magnetfeldlinien und ein großer Überlappungszone 22 der elektromagnetischen Felder (40) benachbarter Induktionsspulen ein.

Die durchgezogenen Linien 41 repräsentieren den Magnetfeldstärkenverlauf, wie er sich ergibt, wenn das Magnetfeld der Heizspule (wie anhand der Kurven 40 angedeutet) von entgegengesetzt gerichteten Magnetfeldern 42; 43 überlagert wird, die sich aufgrund der Gegenwicklungen 31 und 33 einstellen. Dadurch ergibt sich eine Taillierung der ursprünglichen elektromagnetischen Feldes (Kurve 40) und eine deutlich kleinere Überlagerungszone 38 der benachbarten elektromagnetischen Felder. Die Flächengröße der Überlappungszonen 22 und 38 kann jeweils als Maß für den Umfang der Wechselwirkungen der beiderseitigen elektromagnetischen Felder betrachtet werden. Diese Wechselwirkung ist bei den beiderseits taillierten elektromagnetischen Feldern deutlich geringer als bei den nicht taillierten Feldern.

Durch diese Taillierung wird demnach die gegenseitige Wechselwirkung und Kopplung der einzelnen Induktionsverdampfer 10 untereinander verringert. Dadurch kann eine individuelle Leistungsanpassung der einzelnen Verdampfer 10 der Verdampferbank ohne nennenswerte Rückkopplung auf die anderen Verdampfer vorgenommen werden, was die bislang erreichbare Beschichtungsqualität ohne hohe Zusatzkosten deutlich verbessert.

Das Blockschaltbild von **Figur 6** zeigt schematisch den Aufbau und die Regelung der Leistung der Induktionsspulen 4 der Verdampfereinheit 1 am Beispiel dreier baugleicher Einheiten. Jeder der Induktionsverdampfer 10 verfügt über eine wassergekühlte, dreigliedrige Induktionsspule 4. Diese ist aus einem Kupferrohrrohr gewickelt und weist die folgenden Spulenbereiche auf: Eine untere Gegenwindung 31 mit einer Wicklungsrichtung (jeweils betrachtet vom Punkt des Stromeintritts) gegen den Uhrzeigersinn, die eigentliche Heizspule 32 mit einer Wicklungsrichtung im Uhrzeigersinn und eine obere Gegenwicklung 33 mit einer Wicklungsrichtung gegen den Uhrzeigersinn. Die elektrischen Zuführungen sind jeweils über einen Kondensator 61 mit einem Wechselstromgenerator 62 verbunden. Sämtliche Wechselstromgeneratoren 62 der Verdampfereinheit sind mit einer zentralen Steuereinheit 63 verbunden. In die Steuereinheit 63 werden die Messdaten der Schichtdickenmessung von den einzelnen Schichtdickensensoren 14 über Datenleitungen 64 zugeführt. Auf Basis der Daten werden die einzelnen Wechselstromgeneratoren 62 über die Steuerleitung 65 individuell angesteuert.

Das elektromagnetische Feld der einzelnen Induktionsspulen 4 stellt eine Störgröße der Leistungsregelung dar, die in Figur 6 schematisch durch einen bidirektionalen Richtungspfeil 66 symbolisiert ist, die sich im realen System allerdings mehr oder weniger auf alle benachbarten elektromagnetischen Felder auswirkt.

Die Anzahl der Wechselstromgeneratoren kann auch niedriger sein als die Anzahl der Induktionsverdampfer. Bei einer alternativen bevorzugten Ausführungsform ist daher anstelle der individuellen Stromversorgungen (62) für jeden der Induktionsverdampfer 10 ein gemeinsamer Wechselstromgenerator für die Stromversorgung einiger oder aller Induktionsverdampfer vorgesehen; im einfachsten Fall genügt ein einziger Wechselstromgenerator. Um dennoch eine individuelle Ansteuerung der Heizleistung aller Induktionsverdampfer gewährleisten zu können, ist in diesen Fällen der Wechselstromgenerator beziehungsweise jeder der Wechselstromgeneratoren mit elektrischen Abzweigungen in Form sogenannter Transduktoren versehen, deren Anzahl denen der Induktionsverdampfer entspricht.

Nachfolgend wird ein Beispiel für das erfindungsgemäße Verfahren anhand der Figuren näher erläutert.

Die Verdampfereinheit 1 wird eingesetzt, um eine Verpackungsfolie 9 mit einer Aluminiumschicht zu versehen. Die Grafittiegel 2 werden mit Aluminium gefüllt und mittels der individuellen Hochfrequenzgeneratoren 62 und den Induktionsspulen 4 auf eine Temperatur um 1400 °C aufgeheizt. Der Induktorstrom beträgt jeweils etwa 330 A, die Frequenz 10 kHz. Die Leistung der einzelnen Induktionsverdampfer 10 der Verdampferbank ist individuell einstellbar. Sie erfolgt über die Regelung der elektrischen Leistung über die Steuereinheit 63 im Bereich von 10 bis 20 kW.

Die Zufuhrgeschwindigkeit der zu beschichtenden Verpackungsfolie zur Verdampfereinheit 1 beträgt 10 m/s. Die vorgegebene Soll-Schichtstärke der Aluminiumschicht beträgt 10. Die individuelle Leistungsregelung der Induktionsverdampfer 10 erfolgt auf Basis der Schichtdickenmessung. Sobald eine Messeinheit 14 eine Unterschreitung der Soll-Schichtstärke ermittelt, wird die dem betreffenden Induktionsverdampfer 10 zugeführte elektrische Leistung individuell erhöht. Umgekehrt wird bei einer Überschreitung der Soll-Schichtstärke die Leistung des betreffenden Induktionsverdampfers 10 individuell verringert.

Diese individuellen Leistungsänderungen bewirken eine Änderung des elektromagnetischen Feldes des betreffenden Induktionsverdampfers 10 und damit einhergehend eine Änderung der Abdampfrate. Durch den Einsatz der Induktionsspulen 4 mit Gegenwicklungen 31, 33 (wie oben anhand der Figuren 4 bis 6 erläutert) wirkt sich die Änderung des elektromagnetischen Feldes auf die benachbarten elektromagnetischen Felder deutlich weniger aus, als dies bei Einsatz von Induktionsverdampfern ohne Gegenwicklung der Fall wäre. Dadurch kann die Verdampfungsrate jedes Induktionsverdampfers individuell optimiert werden, ohne dass es zu unerwünschten Rückkopplungen auf die Verdampfungsrate bei den anderen Induktionsverdampfern kommt.

## Patentansprüche

1. Verdampfersystem zur Beschichtung eines in einer Beschichtungsebene (12) bewegten, bandförmigen Substrats (9) mit einem Beschichtungsmaterial (17),
o mit einer Verdampferbank, die eine Vielzahl von Induktionsverdampfern (10) aufweist, die unterhalb der Beschichtungsebene (12) angeordnet sind und die jeweils einen Tiegel (2) zur Aufnahme des zu verdampfenden Beschichtungsmaterials (17) und eine den Tiegel (2) umgebende Induktions-Heizspule (4; 32) umfassen,
o mit einem Hochfrequenzgenerator (62), mittels dem ein Heizwechselstrom in die Heizspule (4; 32) eingespeist und ein primäres elektromagnetisches Feld (37) erzeugt wird, das durch induktive Einkopplung den Tiegel (2) erhitzt,
o und mit einer Stelleinrichtung (63), mittels der der Heizwechselstrom für jede der Heizspulen (4; 32) individuell eingestellt wird,
**dadurch gekennzeichnet, dass** dem oberen und/oder dem unteren Ende der Induktions-Heizspule (4; 32) eine Induktions-Gegenwicklung (31; 33) zugeordnet ist, in die ein Gegenwechselstrom einspeisbar und dadurch ein sekundäres elektromagnetisches Feld (36) erzeugbar ist, das das primäre elektromagnetische Feld (37) teilweise neutralisiert.

2. Verdampfersystem nach Anspruch 1, **dadurch gekennzeichnet, dass** die teilweise Neutralisierung durch das sekundäre elektromagnetische Feld (36) durch Richtung, Stärke oder Frequenz des Gegenwechselstroms einstellbar ist.

3. Verdampfersystem nach Anspruch 1 oder 2, **dadurch gekennzeichnet, dass** der Gegenwechselstrom eine Richtung im Raum hat, die entgegengesetzt zur räumlichen Richtung des Heizwechselstroms ist.

4. Verdampfersystem nach einem der vorhergehenden Ansprüche, **dadurch gekennzeichnet, dass** die Induktions-Heizspule (4; 32) und die Gegenwicklung (31; 33) ein integrales Bauteil (4) bilden, das an den Hochfrequenzgenerator (6) angeschlossen ist.

5. Verdampfersystem nach einem der vorhergehenden Ansprüche, **dadurch gekennzeichnet, dass** die Gegenwicklung (31; 33) einwindig oder zweiwindig und die Heizspule (32) mehrwindig ausgeführt ist.

6. Verfahren zum Beschichten eines bandförmigen Substrats (9) mit einem Beschichtungsmaterial (17), umfassend die Verfahrensschritte
(a) Transportieren des Substrats (9) in einer Beschichtungsebene (12),
(b) Bereitstellen einer Verdampferbank, die eine Vielzahl von Induktionsverdampfern (10) aufweist, die unterhalb der Beschichtungsebene (12) angeordnet sind und die jeweils einen Tiegel (2) zur Aufnahme des zu verdampfenden Beschichtungsmaterials (17) und eine den Tiegel (2) umgebende Induktions-Heizspule (4) umfassen,
(c) Erhitzen und Verdampfen des Beschichtungsmaterials (17) unter Einsatz eines Hochfrequenzgenerators (62), mittels dem ein Heizwechselstrom in die Induktions-Heizspule (4) eingespeist und ein primäres elektromagnetisches Feld (37) erzeugt wird, das durch induktive Einkopplung den Tiegel (2) erhitzt,
(d) Individuelles Einstellen des Heizwechselstroms für jede der Heizspulen (4),
wobei Induktionsverdampfer (10) eingesetzt werden, bei denen jeweils dem oberen und/oder dem unteren Ende der Heizspule (32) eine Induktions-Gegenwicklung (31; 33) zugeordnet ist, in die ein Gegenwechselstrom eingespeist und dadurch ein sekundäres elektromagnetisches Feld (36) erzeugt wird, das das primäre elektromagnetische Feld (37) teilweise neutralisiert.

7. Verfahren nach Anspruch 6, **dadurch gekennzeichnet, dass** die teilweise Neutralisierung durch das sekundäre elektromagnetische Feld (36) durch Richtung, Stärke oder Frequenz des Gegenwechselstroms eingestellt wird.

8. Verfahren nach Anspruch 6 oder 7, **dadurch gekennzeichnet, dass** der Gegenwechselstrom eine Richtung im Raum hat, die entgegengesetzt zur räumlichen Richtung des Heizwechselstroms ist.

9. Verfahren nach einem der Ansprüche 6 bis 8, **dadurch gekennzeichnet, dass** der Heizwechselstrom und der Gegenwechselstrom dieselbe Frequenz haben.

## Claims

1. Vaporizer system for coating a strip-shaped substrate, which is moved in a coating plane (12), with a coating material, comprising
• a vaporizer bank which comprises a plurality of induction vaporizers (10) which are arranged below the coating plane (12) and of which each comprises a crucible (2) for receiving the coating material (17) to be vaporized and an induction heating coil (4; 32) surrounding the crucible (2)
• a high-frequency generator (62) which serves to feed a heating alternating current into the heating coil (4; 32) and to generate a primary electromagnetic field (37) which heats the crucible (2) through inductive coupling,
• and a setting device (63) which serves to set the heating alternating current for each of the heating coils (4; 32) individually,
**characterized in that** an induction counter-winding (31; 33) is assigned to the upper and/or the lower end of the induction heating coil (4; 32), into which counter-winding an opposing alternating current can be fed, thereby making it possible to generate a secondary electromagnetic field (36) which partially neutralizes the primary electromagnetic field.

2. Vaporizer system according to claim 1, **characterized in that** the partial neutralization by the secondary electromagnetic field (36) is adjustable by direction, strength or frequency of the opposing alternating current.

3. Vaporizer system according to claim 1 or 2, **characterized in that** the opposing alternating current has a direction in space which is opposite to the spatial direction of the heating alternating current.

4. Vaporizer system according to any one of the preceding claims, **characterized in that** the induction heating coil (4; 32) and the counter winding (31; 33) form an integral component (4) connected to the high-frequency generator (6).

5. Vaporizer system according to any one of the preceding claims, **characterized in that** the counter winding (31; 33) is single-winded or two-winded and the heating coil (32) is multi-winded.

6. Method for coating a strip-shaped substrate (9) with a coating material (17) comprising the method steps of
(a) transporting the substrate (9) in a coating plane (12),
(b) providing a vaporizer bank comprising a plurality of induction vaporizers (10) which are arranged below the coating plane (12) and of which each comprises a crucible (2) for receiving the coating material (17) to be vaporized and an induction heating coil (4) surrounding the crucible (2),
(c) heating and vaporizing the coating material (17) using a high-frequency generator (62) which serves to feed a heating alternating current into the induction heating coil (4) and to generate a primary electromagnetic field (37) which heats the crucible (2) by inductive coupling,
(d) individually adjusting the heating alternating current for each of the heating coils (4),
wherein induction vaporizers (10) are used, in which an induction counter-winding (31; 33) is respectively assigned to the upper and/or the lower end of the heating coil (32), into which counter-winding an opposing alternating current is fed and thereby a secondary electromagnetic field (36) is generated, which partially neutralizes the primary electromagnetic field (37).

7. Method according to claim 6 **characterized in that** the partial neutralization by the secondary electromagnetic field (36) is adjusted by direction, strength or frequency of the opposing alternating current.

8. Method according to claim 6 or 7, **characterized in that** the opposing alternating current has a direction in space which is opposite to the spatial direction of the heating alternating current.

9. Method according to any one of claims 6 to 8, **characterized in that** the heating alternating current and the opposing alternating current have the same frequency.

## Revendications

1. Système de vaporisateurs destiné au revêtement d'un substrat en bandes (9), se déplaçant dans un plan de revêtement (12), avec un matériau de revêtement (17),
• avec un banc de vaporisateurs, présentant une pluralité de vaporisateurs par induction (10) qui sont agencés au-dessous du plan de revêtement (12) et qui incluent à chaque fois un creuset (2) destiné à recevoir le matériau de revêtement (17) à vaporiser et une bobine de chauffage par induction (4, 32) entourant le creuset (2),
• avec un générateur à haute fréquence (62), au moyen duquel la bobine de chauffage (4, 32) est alimentée avec un courant alternatif de chauffage, et un champ électromagnétique primaire (37) est généré, lequel chauffe le creuset (2) par couplage inductif,
• et avec un dispositif de réglage (63) au moyen duquel le courant alternatif de chauffage est réglé individuellement pour chacune des bobines de chauffage (4, 32),
**caractérisé en ce qu'**un enroulement différentiel (31; 33) par induction est alloué à l'extrémité supérieure et/ou inférieure de la bobine de chauffage par induction (4, 32), lequel peut être alimenté avec un contre-courant alternatif et ainsi un champ électromagnétique secondaire (36) peut être généré lequel neutralise partiellement le champ électromagnétique primaire (37).

2. Système de vaporisateurs selon la revendication 1, **caractérisé en ce que** la neutralisation partielle par le champ électromagnétique secondaire (36) peut être réglée par la direction, la force ou la fréquence du contre-courant alternatif.

3. Système de vaporisateurs selon la revendication 1 ou 2, **caractérisé en ce que** le contre-courant alternatif présente une direction dans l'espace qui est opposée à la direction spatiale du courant alternatif de chauffage.

4. Système de vaporisateurs selon l'une quelconque des revendications précédentes, **caractérisé en ce que** la bobine de chauffage par induction (4, 32) et l'enroulement différentiel (31, 33) forment un composant intégral (4) qui est raccordé au générateur à haute fréquence (6).

5. Système de vaporisateurs selon l'une quelconques des revendications précédentes, **caractérisé en ce que** l'enroulement différentiel (31, 33) est conçu de façon monospire ou bispire et la bobine de chauffage (32) est conçu de façon multispire.

6. Procédé de revêtement d'un substrat (9) en bandes avec un matériau de revêtement (17) comprenant les étapes du procédé consistant à :
(a) transporter le substrat (9) dans un plan de revêtement (12),
(b) fournir un banc de vaporisateurs, présentant une pluralité de vaporisateurs par induction (10) qui sont agencés au-dessous du plan de revêtement (12) et qui comprennent à chaque fois un creuset (2) destiné à recevoir le matériau de revêtement (17) à vaporiser et une bobine de chauffage par induction (4, 32) entourant le creuset (2),
(c) chauffer et vaporiser le matériau de revêtement (17) en utilisant un générateur à haute fréquence (62), au moyen duquel un courant alternatif de chauffage est injecté dans la bobine de chauffage (4, 32) par induction, et un champ électromagnétique primaire (37) est généré, lequel chauffe le creuset (2) par couplage inductif,
(d) régler individuellement le courant alternatif de chauffage pour chacun des bobines de chauffage (4),
des vaporisateurs par induction (10) étant utilisés, auxquels un enroulement différentiel (31, 33) par induction (31, 33) est alloué à chaque fois à l'extrémité supérieure et/ou inférieure de la bobine de chauffage (32), dans lequel un contre-courant est injecté et ainsi un champ électromagnétique secondaire (36) est généré lequel neutralise partiellement le champ électromagnétique primaire (37).

7. Procédé selon la revendication 6, **caractérisé en ce que** la neutralisation partielle par le champ électromagnétique secondaire (36) est réglée en fonction de la direction, de la force ou de la fréquence du contre-courant alternatif.

8. Procédé selon la revendication 6 ou 7, **caractérisé en ce que** le contre-courant alternatif présente une direction dans l'espace qui est opposée à la direction spatiale du courant alternatif de chauffage.

9. Procédé selon l'une des revendications 6 à 8, **caractérisé en ce que** le courant alternatif de chauffage et le contre-courant alternatif ont la même fréquence.
